(19) **Europäisches Patentamt**

**European Patent Office**

**Office européen des brevets**

(11) Veröffentlichungsnummer: **0 250 799 B1**

## (12) EUROPÄISCHE PATENTSCHRIFT

(45) Veröffentlichungstag der Patentschrift: **11.03.92**

(21) Anmeldenummer: **87106885.4**

(22) Anmeldetag: **12.05.87**

(51) Int. Cl.⁵: **G01R 31/34**, G01R 27/02, H02H 7/08

(54) **Verfahren zur Überwachung einer Asynchronmaschine.**

(30) Priorität: **23.05.86 DE 3617452**
**10.03.87 DE 3707614**

(43) Veröffentlichungstag der Anmeldung:
**07.01.88 Patentblatt 88/01**

(45) Bekanntmachung des Hinweises auf die
Patenterteilung:
**11.03.92 Patentblatt 92/11**

(84) Benannte Vertragsstaaten:
**CH DE FR GB IT LI SE**

(56) Entgegenhaltungen:
**EP-A- 0 047 900**
**DE-A- 3 034 275**
**US-A- 4 303 882**
**US-A- 4 442 393**

(73) Patentinhaber: **KSB Aktiengesellschaft**
**Johann-Klein-Strasse 9**
**W-6710 Frankenthal(DE)**

(72) Erfinder: **Nold, Stefan**
**Mollerstrasse 28**
**W-6100 Darmstadt(DE)**

**Beschreibung**

Die Erfindung betrifft ein Verfahren zur Überwachung des Zustandes einer Asynchronmaschine durch Bestimmung von den Zustand der Asynchronmaschine charakterisierenden Parametern aus den bei laufender Asynchronmaschine ermittelten komplexen Eingangsimpedanzen.

Die Überwachung laufender elektrischer Maschinen mit Hilfe von Meßinstrumenten, die Betriebsdaten, wie Drehzahl, Temperatur usw. übermitteln, erfolgte bisher insbesondere im Hinblick auf zu erfüllende Funktionen der Maschine. Daneben wurde aber auch eine Überwachung auf eintretende Störungen vorgenommen. Es lag allerdings in der Natur der verwendeten Verfahren und Instrumente, daß vielfach erst der eingetretene Schaden angezeigt wurde. Eine Fehlerfrüherkennung war damit weitgehend ausgeschlossen. Die Messung mechanischer Größen machte im übrigen einen hohen Aufwand notwendig.

Es wurden auch bereits Verfahren entwickelt, die eine Fehlererkennung aufgrund der Auswertung elektrischer Messungen ermöglichen.

So ist es durch die US-A-4 442 393 bekannt, aus der bei laufender Maschine ermittelten komplexen Eingangsimpedanz und mehreren als bekannt vorausgesetzten Parametern, wie Haupt- und Streuinduktivität, den Statorwiderstand und damit die Statortemperatur zu bestimmen. Allerdings variieren die als bekannt vorausgesetzten Parameter von Maschine zu Maschine. Sie sind beispielsweise abhängig von der Blechqualität, aber auch von der Betriebsspannung. So ergeben sich Sättigungseffekte bei erhöhter Betriebsspannung und damit eine Verringerung der Hauptinduktivität. Hieraus resultieren Fehler bei der Bestimmung des Statorwiderstands. Im übrigen können Fehler, die eine Änderung der als gegeben vorausgesetzten Parameter nach sich ziehen, nicht erkannt werden.

Durch die DE-A-3 034 275 ist es bekannt, aus elektrischen Messungen einen der Parameter Hauptinduktivität, Streuinduktivität oder Statorwiderstand einer Asynchronmaschine zu bestimmen, wenn die jeweils anderen Parameter bekannt sind. Die ermittelten Parameter werden in Speichern abgelegt. Auch hier gilt, daß sich aus einer Änderung der als bekannt vorausgesetzten Parameter Ungenauigkeiten und Fehler ergeben, die sich bei Bestimmung des unbekannten Parameters niederschlagen.

Der Erfindung liegt die Aufgabe zugrunde, ein Verfahren der eingangs genannten Art zu schaffen, das bei ans Netz angeschlossenen Asynchronmaschinen mit geringem Aufwand und ohne eine Messung mechanischer Größen einen hohen Aussagegehalt besitzt, also vor allem einen frühzeitigen Rückschluß auf sich anbahnende Maschinenfehler zuläßt.

Die gestellte Aufgabe wird erfindungsgemäß mit Hilfe des im Anspruch 1 genannten Verfahrens gelöst.

Ein Vorteil des erfindungsgemäßen Verfahrens liegt darin, daß deren Bestimmungsgleichung linear in den Parametern ist, so daß die Bestimmung der Parameter mit Hilfe der Methode der kleinsten Fehlerquadrate oder mittels eines ähnlichen Verfahrens direkt möglich ist. Ein weiterer Vorteil des erfindungsgemäßen Verfahrens liegt in dem Umstand, daß ausgenommen bei der Ermittlung des Läuferwiderstandes und der Läufertemperatur die Drehzahl und der Schlupf nicht erfaßt werden müssen und daß eine Veränderung des Läuferwiderstandes nicht berücksichtigt werden muß.

Die Unteransprüche nennen zweckmäßige Ausgestaltungen des erfindungsgemäßen Verfahrens. Sie beziehen sich insbesondere auf die durch dieses Verfahren ermöglichte Überwachung der Hauptinduktivität, der Streuinduktivität, des Ständer- und des Läuferwiderstandes. Eine derartige Überwachung gibt beispielsweise Aufschluß über mechanische Brüche und Überhitzungen.

Vor allem kann mit Hilfe des erfindungsgemäßen Verfahrens eine wenig aufwendige Luftspaltüberwachung realisiert werden, da die Hauptinduktivität umgekehrt proportional zum ideellen Luftspalt der Asynchronmaschine ist. Die Hauptinduktivität kann damit als Anzeige für die Größe des Luftspaltes angesehen werden. Diese Größe gibt wiederum Aufschluß über eine mögliche Korrosion, über Lagerdefekte oder eine Wellenverkrümmung. Aus dem Umstand, daß die überwiegende Mehrzahl der Maschinendefekte durch die vorgenannten Fehler hervorgerufen wird, ergibt sich der Wert des erfindungsgemäßen Verfahrens für die Fehlerfrüherkennung.

Dem besseren Verständnis des erfindungsgemäßen Verfahrens soll die folgende Herleitung dienen:

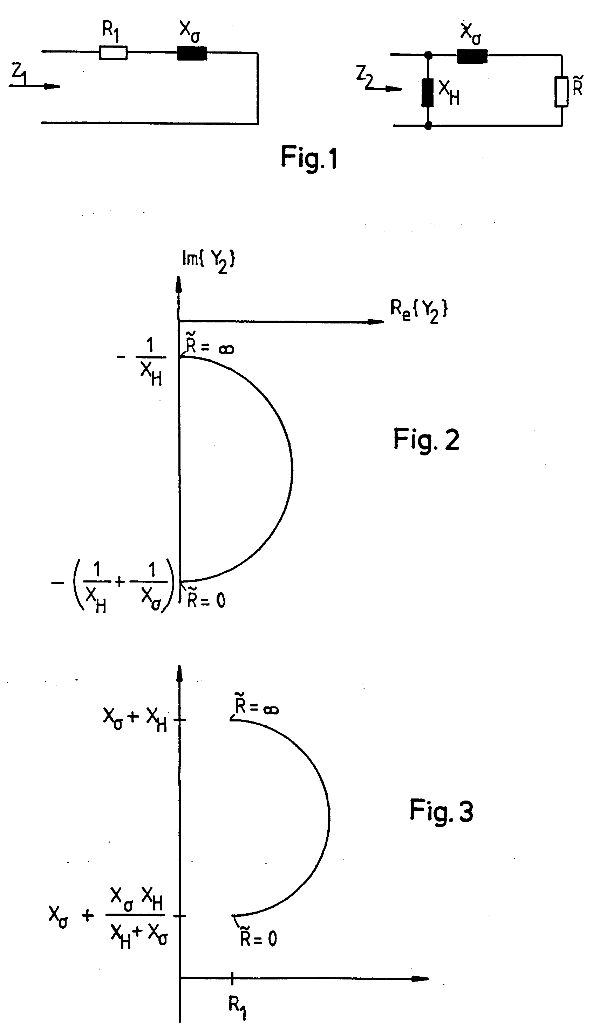

Das T-Ersatzschaltbild der Asynchronmaschine kann als Reihenschaltung zweier Impedanzen $Z_1$ und $Z_2$ aufgefaßt werden, die in Fig. 1 definiert sind. Danach gilt

$$Z = Z_1 + Z_2$$

$$Y_2 = \frac{1}{Z_2} = \frac{1}{jX_H} + \frac{1}{\tilde{R} + jX_\sigma} \qquad (1)$$

Die Ortskurve der Admittanz $Y_2$ (  ) ist ein Halbkreis, wie in Fig. 2 dargestellt. Die Ortskurve der Impedanz $Z_2$ (  ) ist ebenfalls ein Halbkreis, da $Z_2 = 1/Y_2$ eine lineare konforme Abbildung ist. Weil $Z_1$ unabhängig von   ist, ist die Ortskurve der Eingangsimpedanz $Z = Z_1 + Z_2$ ein Halbkreis, wie in Fig. 3 dargestellt. Die Parameter des Kreises sind:
Koordinaten des Mittelpunktes:

$$\left( \frac{A_2}{2}, \frac{A_1}{2} \right)$$

$$\frac{A_2}{2} = R_1 \qquad (2)$$

$$\frac{A_1}{2} = X_\sigma + \frac{X_\sigma X_H}{X_\sigma + X_H} + \frac{D}{2} \qquad (3)$$

D ist hierbei der Durchmesser des Halbkreises. Es gilt:

$$D = X_H - \frac{X_\sigma X_H}{X_\sigma + X_H} \qquad (4)$$

Die Gleichung für den Halbkreis lautet dann:

$$\left( R - \frac{A_2}{2} \right)^2 + \left( X - \frac{A_1}{2} \right)^2 = \left( \frac{D}{2} \right)^2 \qquad (5)$$

Diese kann direkt in die Schätzgleichung, wie sie im Hauptanspruch definiert ist, umgeformt werden:

$$\left[ R^2 + X^2 \right] = A_1 \cdot X + A_2 \cdot R + A_3 \qquad (6)$$

$$\text{mit} \quad A_3 = \frac{D^2 - A_1^2 - A_2^2}{4} \qquad (7)$$

Die Gleichungen (2), (3), (4) und (7) lassen sich jetzt leicht umformen. Aus Gleichung (4) folgt

$$X_\sigma X_H = (X_H - D)(X_\sigma + X_H) \quad (8)$$

$$X_\sigma = \frac{X_H^2}{D} - X_H \qquad (9)$$

Bei Einsetzen von (4) und (9) in (3) ergibt sich:

$$\frac{A_1}{2} = \frac{X_H^2}{D} - X_H + X_H - D + \frac{D}{2} \qquad (10)$$

Daraus ergibt sich wiederum:

$$X_H = \sqrt{\frac{D}{2}(A_1 + D)} \qquad (11)$$

$$\text{und } X_\sigma = \frac{1}{2}\left[ A_1 + D\left(1 - \sqrt{2} \cdot \sqrt{1 + \frac{A_1}{D}}\right)\right] \qquad (12)$$

Die Haupt- und Streuinduktivitäten erhält man dann durch Division der Reaktanzen $X_H$ und $X_\sigma$ durch die mit $2\pi$ multiplizierte Netzfrequenz, so daß man die Verfahren nach den Ansprüchen 2 und 3 erhält. Die Gleichung (2) beinhaltet das Verfahren nach Anspruch 4.

Obwohl manche reale Asynchronmaschinen keine konstanten Induktivitäten und Widerstände für das Ersatzschaltbild aufweisen, führt die genannte Schätzgleichung zu einem Satz von konstanten Parametern. Sie ist damit auch zur Überwachung dieser Asynchronmaschinen geeignet.

Mit dem Verfahren gemäß Anspruch 6 -zusammen mit den Verfahren gemäß den Ansprüchen 1 bis 5-, in dem ebenfalls von der Hauptinduktivität $L_H$ und der Streuinduktivität $L_\sigma$ sowie den daraus bestimmten Reaktanzen ausgegangen wird, läßt sich die Temperatur des Läufers im Betrieb ermitteln. Bisher benötigte man dafür zusätzliche Einrichtungen, beispielsweise in Verbindung mit Schleifringen, die verschleiß- und störanfällig waren.

Anhand der folgenden Herleitung wird der Hintergrund des Verfahrens näher erläutert:
Ausgehend von dem T-Ersatzschaltbild der Asynchronmaschine ergibt sich für die Eingangsimpedanz:

$$Z = R_1 + jX_\sigma + jX_H \, \frac{jX_\sigma + \dfrac{R_2}{s}}{\dfrac{R_2}{s} + j(X_\sigma + X_H)}$$

Der Imaginärteil ist dann:

$$X = X_\sigma + X_H \, \frac{\dfrac{R_2^2}{s^2} + (X_\sigma + X_H)X_\sigma}{\dfrac{R_2^2}{s^2} + (X_\sigma + X_H)^2}$$

Die Isolierung von

4

$$\frac{R_2}{s}$$

führt zu:

$$\left(\frac{R_2}{s}\right)^2 (X - X_\sigma - X_H) = X_\sigma X_H (X_\sigma + X_H) - (X - X_\sigma)(X_\sigma + X_H)^2$$

wegen

$$X_H X_\sigma (X_H + X_\sigma) + X_\sigma (X_H + X_\sigma)^2 = (X_H + X_\sigma)^3 \sigma$$

gilt dann

$$R_2 = s (X_H + X_\sigma) \sqrt{\frac{\dfrac{X}{X_H + X_\sigma} - \sigma}{1 - \dfrac{X}{X_H + X_\sigma}}} \ .$$

## Patentansprüche

1.  Verfahren zur Überwachung des Zustandes einer Asynchronmaschine durch Bestimmung von den Zustand der Asynchronmaschine charakterisierenden Parametern aus den bei laufender Asynchronmaschine ermittelten komplexen Eingangsimpedanzen, **dadurch gekennzeichnet,** daß bei mindestens drei nicht identischen Betriebspunkten die komplexe Eingangsimpedanz Z bestimmt wird, daß jedes Wertepaar für den Realteil R und den Imaginärteil X der Eingangsimpedanz Z = R + jX, das man pro Betriebspunkt erhält, jeweils in die Gleichung

    $$(R^2 + X^2) = A_1 \cdot X + A_2 \cdot R + A_3$$

    mit unbekannten Parametern $A_1$, $A_2$ und $A_3$ eingesetzt wird, daß aus dem so erhaltenen Gleichungssystem die den Zustand der Asynchronmaschine charakterisierenden Parameter $A_1$, $A_2$ und $A_3$ ermittelt werden und daß die ermittelten Parameter $A_1$, $A_2$ und $A_3$ mit Bezugswerten $A_1^*$, $A_2^*$ und $A_3^*$ verglichen werden, die einen Vergleichszustand charakterisieren.

2.  Verfahren zur Überwachung der Hauptinduktivität $L_H$ einer Asynchronmaschine nach Anspruch 1, dadurch gekennzeichnet, daß die ermittelten Parameter $A_1$, $A_2$ und $A_3$ zur Bildung einer Hilfsgröße D herangezogen werden, wobei

    $$D = \sqrt{A_1^2 + A_2^2 + 4 A_3}$$

    zusammen mit den Werten für $A_1$ und f, welches die Frequenz der Spannung ist, mit der die Speisung der Asynchronmaschine erfolgt, in folgende, die Hauptinduktivität $L_H$ ergebende Formel eingesetzt wird:

5

$$L_H = \frac{1}{2 \pi f} \sqrt{\frac{D}{2}(D + A_1)} \; .$$

3. Verfahren zur Überwachung der Streuinduktivität $L_\sigma$ einer Asynchronmaschine nach Anspruch 1, dadurch gekennzeichnet, daß die ermittelten Parameter $A_1$, $A_2$ und $A_3$ zur Bildung einer Hilfsgröße

$$D = \sqrt{A_1{}^2 + A_2{}^2 + 4 A_3}$$

verwendet werden, wobei sich aus den so gefundenen Werten die Streuinduktivität

$$L_\sigma = \frac{1}{4 \pi f} \left[ A_1 + D \left( 1 - \sqrt{2} \sqrt{1 + \frac{A_1}{D}} \right) \right]$$

ergibt und wobei f die Frequenz des Spannung ist, mit der die Speisung der Asynchronmaschine erfolgt.

4. Verfahren zur Überwachung des Ständerwiderstandes einer Asynchronmaschine nach Anspruch 1, dadurch gekennzeichnet, daß der Ständerwiderstand mit Hilfe des ermittelten Parameters $A_2$ mittels der Gleichung

$$R_1 = \frac{A_2}{2}$$

bestimmt wird.

5. Verfahren zur Bestimmung des Läuferwiderstandes einer Asynchronmaschine nach den Ansprüchen 1 bis 3 **dadurch gekennzeichnet,** daß die Hauptinduktivität $L_H$ und die Streuinduktivität $L_\sigma$ ermittelt und deren zugehörige Reaktanzen mit $X_H = 2\pi f \cdot L_H$ und $X_\sigma = 2\pi f \cdot L_\sigma$ bestimmt werden, daß die Drehzahl der Asynchronmaschine gemessen wird und daß unter Berücksichtigung des Schlupfes s und der mittels

$$\left\{ \sigma = 1 - \frac{X_H{}^2}{(X_H + X_\sigma)^2} \right\}$$

ermittelten Streuung $\sigma$ der Asynchronmaschine sowie des Imaginärteiles X der Eingangsimpedanz Z der Läuferwiderstand als

EP 0 250 799 B1

$$R_2 = s \left( X_H + X_\sigma \right) \sqrt{\dfrac{\dfrac{X}{X_H + X_\sigma} - \sigma}{1 - \dfrac{X}{X_H + X_\sigma}}}$$

bestimmt wird.

6. Verfahren zur Bestimmung der Läufertemperatur nach Anspruch 1, dadurch gekennzeichnet, daß unter Zugrundelegung einer Wicklungstemperatur von $\vartheta\, R_C = 20\,°C$ und eines Läuferwiderstandes

$$R_{2_C}$$

bei 20 °C aus dem Läuferwiderstand $R_2$ die Läufertemperatur als

$$\vartheta_R = \left( 235° + \vartheta_{R_C} \right) \left( \dfrac{R_2}{R_{2_C}} - 1 \right) + \vartheta_{RC}$$

bestimmt wird.

7. Verfahren nach Anspruch 1, dadurch gekennzeichnet, daß das Verfahren mit einer vorbestimmten Anzahl von Wiederholungen durchgeführt wird, wobei die so erhaltenen Maschinenparameter gespeichert werden, und daß die Maschinenparameter in der Folge zyklisch berechnet und mit den als Referenzgrößen dienenden abgespeicherten Maschinenparametern verglichen werden.

8. Verfahren nach Anspruch 7, dadurch gekennzeichnet, daß der letzte Wert für den $\cos\phi$ der Asynchronmaschine verglichen wird mit den Werten für den $\cos\phi$, die sich aus den letzten M Messungen ergeben, wobei M eine einstellbare natürliche Zahl ist, und daß das neue Wertepaar von Real- und Imaginärteil der Eingangsimpedanz nur dann für das Verfahren nach Anspruch 1 herangezogen wird, wenn der $\cos\phi$ um einen bestimmten einstellbaren Mindestbetrag von allen $\cos\phi$ der letzten M Messungen differiert.

9. Verfahren zur Überwachung des Luftspaltes nach Anspruch 1 und 2, dadurch gekennzeichnet, daß aus dem identifizierten Parameter der Hauptinduktivität $L_H$ der ideelle Luftspalt als weiterer Parameter der Maschine nach der Gleichung

$$d = \dfrac{L_{HN}}{L_H}\, d_N$$

berechnet wird, wobei $L_{HN}$ die vorab abgespeicherte Hauptinduktivität und $d_N$ der konstruktiv vorgesehene Luftspalt ist.

10. Verfahren nach Anspruch 1, dadurch gekennzeichnet, daß zur Bestimmung der Eingangsimpedanz nur jeweils eine Spannung, ein Strom und eine Phasenverschiebung zwischen Spannung und Strom herangezogen werden, wobei bei verketteter Spannung bzw. verkettetem Strom der Strangwert nach den bekannten Symmetriegesetzen ermittelt wird.

7

**Claims**

1.  A method of monitoring the condition of an asynchronous machine by ascertaining the parameters characterizing the condition of the asynchronous machine from the complex input impedances measured while the asynchronous machine is operating, characterized in that at at least three operation points which are not identical, the complex input impedance Z is measured, in that each pair of values for the real part and the imaginary part X of the input impedance $Z = R + jX$, which is obtained for each operation point, is set in the equation

    $(R^2 + X^2) = A_1 \cdot X + A_2 \cdot R + A_3$

    with unknown parameters $A_1$, $A_2$ and $A_2$, that from the equation system obtained in this manner the parameters $A_1$, $A_2$ and $A_2$ are determined which characterize the condition of the asynchronous machine and in that the parameters $A_1$, $A_2$ and $A_3$ obtained are compared with reference values $A_1{}^*$, $A_2{}^*$ and $A_3{}^*$, same characterizing a comparison state.

2.  A method of monitoring the principal inductance $L_H$ of an asynchronous machine as claimed in claim 1, characterized in that the measured parameters $A_1$, $A_2$ and $A_3$ are used to constitute an auxiliary magnitude D, and

    $$D = \sqrt{A_1^2 + A_2^2 + 4A_3}$$

    is used together with the values of $A_1$ and f, which is the frequency of the voltage, with which the asynchronous machine is supplied, in the following formula for the principal inductance $L_H$:

    $$L_H = \frac{1}{2\pi f}\sqrt{\frac{D}{2}(D + A_1)}$$

3.  A method of monitoring the stray inductance $L_\sigma$ of an asynchronous machine as claimed in claim 1, characterized in that the measured parameters $A_1$, $A_2$ and $A_3$ are use to constitute an auxiliary magnitude

    $$D = \sqrt{A_1^2 + A_2^2 + 4A_3}$$

    the values then derived being used to find the stray inductance with the following formula

    $$L_\sigma = \frac{1}{4\pi f}\left[A_1 + D(1 - \sqrt{2}\sqrt{1 + \frac{a_1}{D}})\right]$$

    wherein F denotes the frequency of the voltage with which the asynchronous machine is supplied.

4.  The method of monitoring the stator resistance of an asynchronous machine as claimed in claim 1, characterized in that the stator resistance is ascertained with the aid of the measured parameter A2 using the equation

$$R_1 - \frac{A_2}{2}$$

5. The method of ascertaining the rotor resistance of an asynchronous machine as claimed in claims 1 through 3, characterized in that the principal inductance $L_H$ and the stray inductance $L_\sigma$ are measured and their associated reactances are ascertained with $X_H = 2\pi f \cdot L_H$ and $X_\sigma = 2\pi f \cdot L_\sigma$, in that the speed of rotation of the asynchronous machine is measured and that taking into account the slip s and the electromagnetic leakage $\sigma$ as ascertained by

$$\sigma - 1 - \frac{X_H^2}{(X_H - X_\sigma)^2}$$

and of the imaginary part X of the input impedance Z, the rotor resistance is ascertained as

$$R_2 - s(X_H + X_\sigma)\sqrt{\frac{\dfrac{X}{X_H + X_\sigma} - \sigma}{1 - \dfrac{X}{X_H + X_\sigma}}}$$

6. The method of ascertaining the rotor temperature as claimed in claim 1, characterized in that on the basis of a winding temperature ($\theta_{RC}$) of 20° C and on a rotor resistance ($R_{2c}$) at 20° C the rotor temperature is ascertained from the rotor resistance $R_2$ as

$$\theta_R - (235° + \theta_{R_C})\left(\frac{R_2}{R_{2_c}} - 1\right) + \theta_{R_C}$$

7. The method as claimed in claim 1, characterized in that the method is performed with a predetermined number of repetitions, the machine parameters being stored and that the machine parameters are cyclically computed in order and are compared with the stored machine parameters functioning a reference quantities.

8. The method as claimed in claim 7, characterized in that the last value for the $\cos\phi$ of the asynchronous machine is compared with the $\cos\phi$ values, which result from the last M measurements, M being a set natural number and that the new pair of values for the real and imaginary parts of the input impedance is only used for the method as claimed in claim 1, if the $\cos\phi$ value differs by a certain adjustable minimum amount from all $\cos\phi$ values of the last M measurements.

9. The method of monitoring the air gap as claimed in claim 1 and in claim 2, characterized in that on the basis of the identified parameter for the principal inductance $L_H$ the ideal air gap is computed as a further parameter of the machine in accordance with the equation

$$d - \frac{L_{HN}}{L_H} d_N$$

wherein $L_{HN}$ is the previously stored principle inductance and $d_N$ is the design air gap.

10. The method as claimed in claim 1, characterized in that in order to ascertain the input impedance respectively only one voltage, one current and one phase shift between voltage and current are used, and in the case of linked voltage or, respectively, linked current the phase value is ascertained in accordance with conventional laws of symmetry.

**Revendications**

1. Procédé pour la surveillance de l'état d'une machine asynchrone en déterminant les paramètres caractérisant l'état de la machine asynchrone à partir des impédances d'entrée complexes déterminées lorsque la machine asynchrone est en marche caractérisé en ce que l'impédance d'entrée complexe est déterminée pour trois points de fonctionnement non identiques, en ce qu'à chaque fois les deux valeurs de la composante réelle R et de la composante imaginaire X de l'impédance d'entrée $Z = R + jX$ que l'on obtient pour chaque point de fonctionnement sont utilisées dans l'équation

$$(R^2 + X^2) = A_1 \cdot X + A_2 \cdot R + A_3$$

avec les paramètres inconnus $A_1$, $A_2$ et $A_3$, en ce que à partir du sytème d'équation ainsi obtenu on détermine les paramètres $A_1$, $A_2$ et $A_3$ qui caractérisent l'état de la machine asynchrone et en ce que les paramètres déterminés $A_1$, $A_2$ et $A_3$ sont comparés aux valeurs de référence $A_1^*$, $A_2^*$ et $A_3^*$ qui caractérisent un état de comparaison.

2. Procédé pour la surveillance de l'inductance principale $L_H$ d'une machine asynchrone selon la revendication 1 caractérisé en ce que les paramètres à déterminer $A_1$, $A_2$ et $A_3$ sont utilisés pour former une quantité auxiliaire D telle que

$$D = \sqrt{A_1{}^2 + A_2{}^2 + 4 A_3}$$

et qui avec les valeurs pour $A_1$ et f, fréquence de la tension d'alimentation de la machine asynchrone, est utilisée dans la formule suivante de l'inductance principale $L_H$:

$$L_H = \frac{1}{2\pi f} \sqrt{\frac{D}{2} (D + A_1)} \, .$$

3. Procédé pour la surveillance de l'inductance de fuite $L_\sigma$ d'une machine asynchrone selon la revendication 1 caractérisé en ce que les paramètres déterminés $A_1$, $A_2$ et $A_3$ sont utilisés pour former une quantité auxiliaire

$$D = \sqrt{A_1{}^2 + A_2{}^2 + 4 A_3}$$

telle qu'on obtienne à partir des valeurs ainsi trouvées d'inductance de fuite

$$L_\sigma = \frac{1}{4\pi f} \left[ A_1 + D \left( 1 - \sqrt{2} \sqrt{1 + A_1} \right) \right]$$

et telle que f est la fréquence de la tension avec laquelle la machine asynchrone est alimentée.

4. Procédé pour la surveillance de la résistance du stator d'une machine asynchrone selon la revendication 1 caractérisé en ce que la résistance du stator est déterminée à l'aide du paramètre obtenu $A_2$ au moyen de l'équation

$$R_1 = \frac{A_2}{2}.$$

5. Procédé pour déterminer la résistance du stator d'une machine asynchrone selon les revendications 1 à 3 **caractérisé** en ce que l'inductance principale $L_H$ et l'inductance de fuite L ainsi que leurs réactances correspondantes sont déterminées par $X_H = 2\pi f \cdot L_H$ et $X_\sigma = 2\pi f \cdot L_\sigma$, en ce qu'on mesure le nombre de tours de la machine asynchrone et que, en tenant compte du glissement s et de la fuite $\sigma$ déterminée par

$$\sigma = 1 - \frac{X_H^2}{(X_H + X_\sigma)^2}$$

de la machine asynchrone ainsi que de la composante imaginaire X de l'impédance d'entrée Z, on détermine la résistance du rotor tel que

$$R_2 = s (X_H + X_\sigma) \sqrt{\frac{\dfrac{X}{X_H + X_\sigma} - \sigma}{1 - \dfrac{X}{X_H + X_\sigma}}}$$

6. Procédé pour déterminer la température du rotor selon la revendication 1 caractérisé en ce qu'à partir d'une température de l'enroulement $\vartheta R_C$ de 20°C et d'une résistance de rotor $R_2$ on détermine la température du rotor telle que

$$\vartheta_R = (235° + V_{R_C}) \left( \frac{R_2}{R_{2_C}} - 1 \right) + \vartheta_{RC}.$$

7. Procédé selon la revendication 1 caractérisé en ce que le procédé est répété un nombre précis de fois, les paramètres de la machine ainsi obtenus étant mémorisés, et que les paramètres de la machine sont calculés successivement selon le cycle et comparés aux paramètres mémorisés qui servent de référence.

**8.** Procédé selon la revendication 7 caractérisé en ce que la dernière valeur du cos φ de la machine asynchrone est comparée aux valeurs du cos φ obtenues par les dernières mesures M, M étant un nombre naturel variable, et que on ne tient compte des deux valeurs nouvelles de la composante réelle et de la composante imaginaire de l'impédance d'entrée pour le procédé selon la revendication 1 qu'à la condition que le cos φ diffère de tous les cos φ des dernières M mesures d'un minimum déterminé et variable.

**9.** Procédé pour la surveillance de l'entrefer selon les revendications 1 et 2 caractérisé en ce qu'on calcule à partir du paramètre identifié de l'inductance principale L l'entrefer idéal comme paramètre supplémentaire de la machine selon l'équation

$$d = \frac{L_{HN}}{L_H} \quad d_N$$

dans laquelle $L_{HN}$ est l'inductance principale préalablement mémorisée et $d_N$ l'entrefer prévu sur plan.

**10.** Procédé selon la revendication 1 caractérisé en ce qu'on tient compte pour déterminer l'impédance d'entrée à chaque fois d'une seule tension, d'un courant et d'un décalage de phase entre la tension et le courant et, si la tension ou le courant sont à phases reliées, on détermine la valeur de la phase selon les lois bien connues de la symétrie.

Fig. 1

Fig. 2

Fig. 3